# EUROPEAN PATENT APPLICATION

(11) **EP 1 367 644 A1**
(43) Date of publication of application: **03.12.2003**
(21) Application number: 02425348.6
(22) Date of filing: 29.05.2002
(51) Int. Cl.: H01L 23/495, H01L 21/607, H01L 23/485

(54) **Semiconductor electronic device and method of manufacturing thereof**

(71) Applicant: STMicroelectronics S.r.l., 20041 Agrate Brianza (Milano) (IT)
(72) Inventor: Tiziani, Roberto, 20010 Nerviano, Milano (IT); Renard, Loic, 20041 Agrate Brianza, Milano (IT); Vitali, Battista, 24058 Romano Di Lombardia, Bergamo (IT)
(74) Representative: Zambardino, Umberto

(57) **Abstract**

A semiconductor electronic device (1) is disclosed, which comprises a die (2) of a semiconductor material and a holder (3) connected electrically together by wire leads (4) of copper, the semiconductor material die being formed with a plurality of contact pads (6), the device being characterized in that it comprises a welding stud bump (7) of a metal material selected from a group comprising gold, palladium, and alloys thereof, formed on each contact pad of said plurality of contact pads, each copper wire lead (4) being welded with one end (4a) on a stud bump (7) and with the other end to said holder (3). This electronic device is highly reliable and can be fabricated simply at a low cost.

## Description

### Field of Application

In its general aspect, the present invention relates to an electronic device comprising a die of a semiconductor material that is wire-bonded either to a holder or an integrated circuit having electrically conductive zones.

In particular, the invention relates to an electronic device as above, wherein the semiconductor material die is connected to the holder or the integrated circuit by means of copper wire leads, and to a method of fabricating such a device.

### Prior Art

As is well known, a semiconductor electronic device, e.g. a power device, comprises a die of a semiconductor material that has a surface area of a few square millimeters on which an electronic circuit is monolithically integrated. The die is formed with a plurality of terminals, typically a plurality of surface-formed contact pads for electrical connection to a holder that is an integral part of the electronic device.

The contact pads of a semiconductor material die are typically made of aluminum or an aluminum alloy, as dictated by the manufacture and functionality of such devices.

The holder, known as the "lead frame", may be any of several types, including ceramics substrates, PC boards, flexible circuits, and silicon-based substrates.

The combination of the die and its holder is "packaged", i.e. is coated for heat and mechanical protection of the electronic device throughout its shelf and useful life. The coating is typically of plastics.

The electrical connection of the semiconductor material die to the holder can be established using a number of different techniques, mostly a wire bonding technique. More particularly, each wire has one end welded to a contact pad on the semiconductor material die and the other end welded to a contact pad on a holder to which the die is to be connected.

In the fabrication of semiconductor electronic devices, it is known to use aluminum wires for these electrical connections, which are welded to the contact pads ultrasonically (ultrasonic process). High diameter aluminum wires (up to 500 microns), as are required in high-power electronic devices on account of the high working voltages and current densities that such devices involve, can be welded by this method.

However, the rate of installation of aluminum wire leads by ultrasonic processes is low (usually less than 2 wires per second), and therefore the process is time-consuming. In addition, fairly expensive equipment must be available for installing the wires, which adds to manufacturing costs.

Also known is to connect the semiconductor material die electrically to its holder by means of gold wires, since gold bonds well to the aluminum pads.

Gold wires can be welded to the contact pads by a thermosonic processes, i.e. by the concurrent application of heat and sonic energy. This technique results in a greatly improved rate of gold wire installation, compared with ultrasonic welding (usually raising it to above 10 wires per second), thereby making for more efficient overall processing time.

However, the thermosonic processes employed to establish connections by gold wires result in high manufacturing costs of electronic devices due to the high cost of gold. Thus, the thermosonic processes are usually applied only to the fabrication of low-power electronic devices for which small-diameter gold wires (usually 75 micron or less) can be used for connection to contact pads. Manufacturing costs are only slightly relieved by the higher rate of wire installation, and by the use of thermosonic equipment that is less expensive than ultrasonic equipment.

For example, for each aluminum wire with a 254-micron diameter, which is the most widely used diameter in ultrasonic processes, ten gold wires with a 75-micron diameter are required to ensure the same connection strength. However, if gold wires are used instead of aluminum wire, a substantial increase in manufacturing cost would result.

To obviate these inconvenients, a recent proposal provides for the use of copper rather than gold wires for connecting the semiconductor material die to its holder. Copper is less expensive than gold, and its resistivity is advantageously lower. In addition, copper wires can be welded to the contact pads using the same thermosonic processes as for gold wires, resulting in high installation rates and reduced processing times.

However, copper has a higher hardness (110 Wickers) than gold (60 Wickers) or aluminum (40 Wickers), and this results in a more difficult bonding to the aluminum contact pads, since larger amounts of ultrasonic energy and heat, then higher temperatures must be used to perform bonding.

In this circumstance, it has been found that the increased energy requirements of copper wire welding can damage or crack the semiconductor material die in the pad area or in the semiconductor material. Such a damage or crack is responsible for current and power leakages resulting in unreliable electronic devices. In the extreme cases, the conduction terminals (drain/source or emitter/source) of an electronic device may become short-circuited to each other.

The underlying technical problem of this invention is to provide a semiconductor electronic device comprising a die of a semiconductor material that is connected to the holder by copper wire leads, which involves low manufacturing costs and has appropriate constructional and operational features to overcome the aforementioned shortcomings of the prior art.

### Summary of the Invention

This problem is solved, according to the invention, by a semiconductor electronic device, comprising a die of a semiconductor material and a holder which are connected electrically to each other by copper wire leads, the semiconductor material die being formed with a plurality of contact pads; the semiconductor electronic device being characterized in that it comprises a welding stud bump of a metal material selected from a group comprising gold, palladium, and alloys thereof, formed on each contact pad of said plurality of contact pads, each copper wire lead being welded with one end on a stud bump, and with the other end to said holder.

In the semiconductor device of this invention, each contact pad is usually formed conventionally from aluminum or an aluminum alloy, on the semiconductor material die.

The welding stud bump is formed conventionally by welding the metal material to a contact pad, preferably using thermosonic welding processes. Preferably, the welding stud bump is in the shape of an oblate sphere 10 to 50 microns high.

A preferred material for the welding stud bumps is gold or an alloy thereof.

Each copper wire is welded by a conventional thermosonic process with one end to the welding stud bump formed on a contact pad. This process usually provides for a copper ball to be formed by melting one end of the copper wire and then the copper ball is pressed onto the welding stud bump while ultrasonic energy and optionally heat is applied to weld the ball and the stud bump together. Accordingly, the copper wire end welded on the stud bump will take an oblate spherical shape.

It has been surprisingly found that by having the stud bumps formed from the above-specified metals on the contact pads of the semiconductor material die, the risk of cracking or damaging the semiconductor material die as the copper wires are welded is strongly reduced. In practice, the metal material of the stud bump has been found to effectively absorb most of the compression stress, vibration and/or thermal energy involved in the wire lead welding process, thereby preserving the contact pads and the semiconductor material of the die from crack failure or damage.

In this way, the proportion of rejects from faulty or unreliable electronic devices, or short-circuited devices, can be reduced substantially.

In this respect, it should be noted that the manufacture of copper wire-bonded electronic devices exhibits a rather high percentage of rejects, approximately 50% of the output. Differently, in this invention, this percentage is advantageously brought down up to zero rejects.

This is achieved at low manufacturing costs, in all cases lower than the costs involved in thermosonic methods where gold wires are used for the electrical connections. In this respect, it should be noted that the added cost for the materials, such as gold and/or palladium, used for forming the welding stud bumps is quite marginal because such materials are only used in very small amounts.

It should be further noted that the stud bumps on the contact pads can be formed, and the copper wires welded to the stud bumps, using a thermosonic technique. This advantageously improves the rate of installation of copper wires and, hence, the time for manufacturing the electronic device of this invention is reduced. Advantageously, the electronic device fabricating process of this invention can be optimized and standardized using the same thermosonic technique to provide both the stud bumps and the copper wire connections, by using either a single apparatus or two apparatus in series with the production line.

This invention further relates to a method of fabricating a semiconductor electronic device comprising a die of a semiconductor material and a holder connected electrically together by copper wire leads, the semiconductor material die being formed with a plurality of contact pads, the method being characterized in that it comprises the steps of:
- forming a welding stud bump of a metal material selected from a group comprising gold, palladium, and alloys thereof on each contact pad of said plurality of contact pads; and
- welding one end of a copper wire on a stud bump and the other end to said holder.

Preferably, the step of forming the stud bump comprises welding said metal material to a respective contact pad by a thermosonic process. According to this process, a wire of the material for the stud bump is fed through a capillary duct overlying the semiconductor material die, one wire end jutting out of the capillary duct is molten to form a ball of said material, and the ball is pressed onto the contact pad while ultrasonic vibratory energy and heat are applied through the capillary duct. After a predetermined compression period, the ball that has been pressed onto the contact pad is separated from the wire to leave on the pad a stud bump of substantially oblate spherical shape for later weld connection to the copper wire.

Preferably, the copper wire welding is performed using a thermosonic process.

Further advantages of the semiconductor electronic device of this invention will be apparent from the following description of an embodiment thereof, given by way of non-limitative example with reference to the accompanying drawing.

### Brief Description of the Drawing

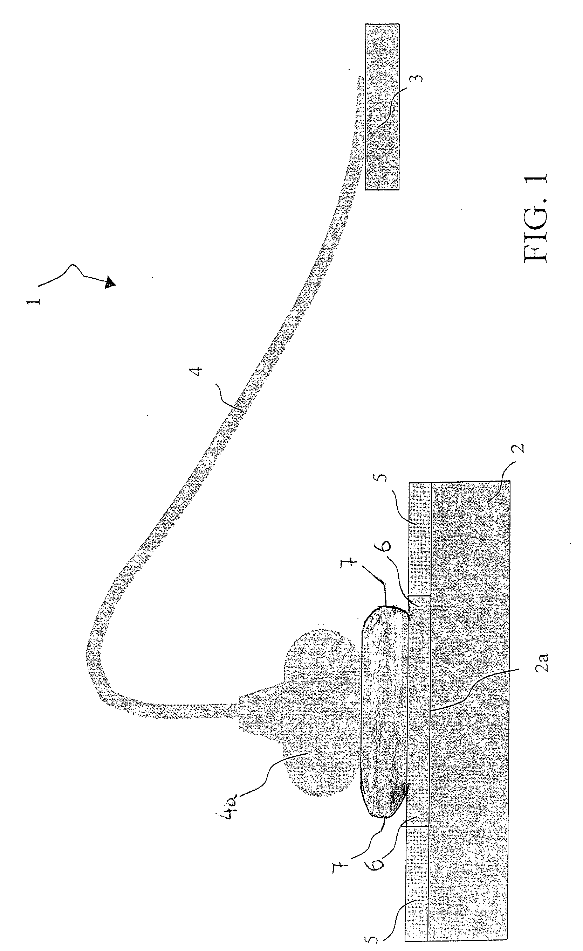

Figure 1 is a sectional view taken through a portion of a semiconductor electronic device according to the invention.

### Detailed Description

With reference to Figure 1, a semiconductor electronic device according to the invention is generally shown at 1. The device 1 comprises a die 2 of a semiconductor material, which is connected electrically to a holder 3 by wire leads 4 of copper. One wire lead 4 is shown in Figure 1 for simplicity. The die 2 comprises an integrated electronic circuit (not shown) and is coated with a layer 5 of an insulating material. This insulating material layer 5 is opened to expose portions 2a of a surface of the die 2 on which respective contact pads of aluminum are formed for connecting the die 2 and holder 3 electrically together. For simplicity, in Figure 1 only a portion 2a of the exposed surface of the die 2 is shown, on which a contact pad, generally shown at 6, is formed.

According to this invention, the electronic device 1 also has a welding stud bump 7 formed from gold and having an oblate spherical shape, the bottom of the stud bump being welded to the contact pad 6 using a thermosonic process.

One end 4a of the copper wire 4 is welded on the top of the stud bump 7 by a thermosonic process. In this process, the end 4a is substantially obtained with an oblate spherical shape for improved strength of the bond to the stud bump 7 beneath.

## Claims

1. A semiconductor electronic device (1) comprising a die (2) of a semiconductor material and a holder (3) connected electrically together by wire leads (4) of copper, the semiconductor material die being formed with a plurality of contact pads (6), the semiconductor electronic device being **characterized in that** it comprises a welding stud bump (7) of a metal material selected from a group comprising gold, palladium, and alloys thereof, formed on each contact pad of said plurality of contact pads, each copper wire lead (4) being welded with one end (4a) on a stud bump (7) and with the other end to said holder (3).

2. An electronic device (1) according to Claim 1, **characterized in that** each contact pad (6) of said plurality of contact pads is formed from aluminum or an alloy thereof.

3. An electronic device (1) according to either Claim 1 or 2, **characterized in that** the welding stud bump (7) is formed from gold.

4. An electronic device (1) according to any of the preceding claims, **characterized in that** the welding stud bump (7) has a substantially oblate spherical shape and height of 10 to 50 microns.

5. An electronic device (1) according to any of the preceding claims, **characterized in that** the end (4a) of the copper wire (4) welded on the stud bump has a substantially oblate spherical shape.

6. A method of fabricating a semiconductor electronic device (1) comprising a die (2) of a semiconductor material and a holder (3) connected electrically together by copper wire leads (4), the semiconductor material die (2) being formed with a plurality of contact pads (6), the method being **characterized in that** it comprises the steps of:
- forming a welding stud bump (7) of metal material selected from a group comprising gold, palladium, and alloys thereof on each contact pad of said plurality of contact pads; and
- welding one end (4a) of a copper wire (4) on a stud bump (7) and the other wire end to said holder (3).

7. A method according to Claim 6, **characterized in that** the welding stud bump (7) is formed by welding the metal material to the contact pad (6) by a thermosonic process.

8. A method according to either Claim 6 or 7, **characterized in that** the end (4a) of the copper wire (4) is welded on the stud bump (7) using a thermosonic welding process.
